# EUROPEAN PATENT APPLICATION

(11) **EP 2 527 857 A2**
(43) Date of publication of application: **28.11.2012**
(21) Application number: 12167766.0
(22) Date of filing: 11.05.2012
(51) Int. Cl.: G01R 33/02

(54) **Three-axis magnetic sensors**

(30) Priority: 26.05.2011 US 201113116844
(71) Applicant: Honeywell International Inc., Morristown, NJ 07962-2245 (US)
(72) Inventor: Rieger, Ryan W., Morristown, NJ New Jersey 07962-2245 (US); Withanawasam, Lakshman, Morristown, NJ New Jersey 07962-2245 (US)
(74) Representative: Houghton, Mark Phillip

(57) **Abstract**

Systems and methods for three-axis magnetic sensors are provided. In one embodiment, a three-axis magnetic sensor formed on a single substrate comprises: an in-plane two-axis magnetic sensor comprising at least one of either a magnetic-resistance (MR) sensor or a magnetic-inductive (MI) sensor formed on the single substrate; and an out-of-plane magnetic sensor comprising a Hall effect sensor formed on the single substrate. The in-plane two-axis magnetic sensor measures magnetic fields in a first plane parallel to a plane of the substrate, and the out-of-plane magnetic sensor measures magnetic fields along an axis orthogonal to the first plane.

## Description

### BACKGROUND

The need for small, low cost three-axis magnetic sensors is growing. Producing sensors sensitive in three orthogonal directions is currently challenging because of the difficulty in forming a single die having both a vertical sensor and horizontal sensors. Traditional technologies involve the rotation of one sensor die so that it provides sensitivity in vertical direction, and then mounting the rotated die onto a substrate or heat frame together with one or more sensors dies providing sensitivity along horizontal axes. These approaches suffer from the difficulty involved in precisely aligning and mounting the sensors dies in such a way to achieve the desired degree of axis orthogonality.

For the reasons stated above and for other reasons stated below which will become apparent to those skilled in the art upon reading and understanding the specification, there is a need in the art for improved three-axis magnetic sensors

### SUMMARY

The Embodiments of the present invention provide methods and systems for improved three-axis magnetic sensors and will be understood by reading and studying the following specification.

Systems and methods for three-axis magnetic sensors are provided. In one embodiment, a three-axis magnetic sensor formed on a single substrate comprises: an in-plane two-axis magnetic sensor comprising at least one of either a magnetic-resistance (MR) sensor or a magnetic-inductive (MI) sensor formed on the single substrate; and an out-of-plane magnetic sensor comprising a Hall effect sensor formed on the single substrate. The in-plane two-axis magnetic sensor measures magnetic fields in a first plane parallel to a plane of the substrate, and the out-of-plane magnetic sensor measures magnetic fields along an axis orthogonal to the first plane.

### DRAWINGS

Embodiments of the present invention can be more easily understood and further advantages and uses thereof more readily apparent, when considered in view of the description of the preferred embodiments and the following figures in which:

Figures 1A and 1B are diagrams respectively illustrating a top view and a side view of a three-axis magnetic sensor package of one embodiment of the present invention;

Figure 1C is a diagram of another three-axis magnetic sensor package of one embodiment of the present invention;

Figure 2 is a diagram illustrating various alternate configurations for embodiments described with respect to Figures 1A-C and Figure 3; and

Figure 3 is a flow chart illustrating a method of one embodiment of the present invention.

In accordance with common practice, the various described features are not drawn to scale but are drawn to emphasize features relevant to the present invention. Reference characters denote like elements throughout figures and text.

### DETAILED DESCRIPTION

In the following detailed description, reference is made to the accompanying drawings that form a part hereof, and in which is shown by way of specific illustrative embodiments in which the invention may be practiced. These embodiments are described in sufficient detail to enable those skilled in the art to practice the invention, and it is to be understood that other embodiments may be utilized and that logical, mechanical and electrical changes may be made without departing from the scope of the present invention. The following detailed description is, therefore, not to be taken in a limiting sense.

Embodiments of the present invention provide chip packages that comprise orthogonal 3-dimensional sensor arrangements by combining two different sensor technologies on a common base. More specifically, embodiments of the present invention provide for 3-dimensional sensor arrangements by combining magnetic sensors (such as Magneto-Resistive (MR) and/or and Magneto-Inductive (MI) sensors, for example), which are sensitive along the plane of the silicon on which they are formed, with vertically sensitive Hall effect magnetic sensors. In one embodiment, these sensors are incorporated into an Application Specific Integrated Circuit (ASIC). Such embodiments provide solutions for realizing devices such as electronic compasses or other devices that utilize the Earth's magnetic field for orientation or navigation purposes.

Magneto-Resistive (MR) sensors (including, for example, anisotropic magneto-resistance (AMR), Giant Magneto-Resistance (GMR), and Tunnel Magneto-resistance (TMR) sensors) and Magneto-Inductive (MI) sensors are sensitive to magnetic fields in plane to the die surface. As such, these sensors are known as in-plane sensors. In contrast, Hall effect sensors are sensitive to magnetic fields perpendicular to the plane of the die surface and are known as out-of-plane sensors. By combining in-plane and out-of-plane sensors, embodiments of the present invention provide for less costly and more size efficient methods of creating a 3-axes magnetic sensor than die rotation methods.

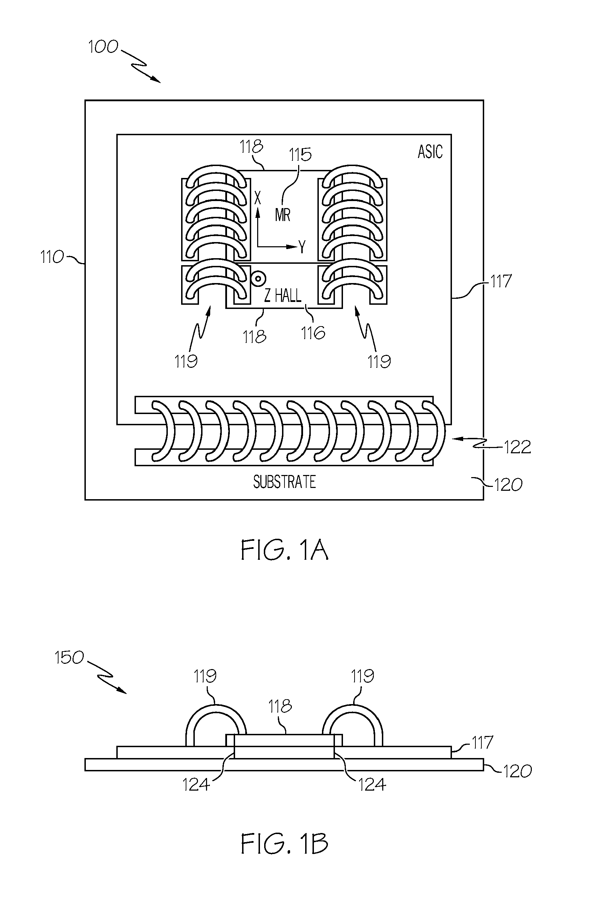

Figures 1A and 1B are diagrams illustrating a top view (at 100) and a side view (at 150) of a three-axis magnetic sensor package 110 having an ASIC 117 formed on a common substrate 120. ASIC 117 comprises an in-plane magnetic sensor in the form of a magneto-resistance sensor 115 and an out-of-plane magnetic sensors in the form of a hall sensor 116, formed on a single chip die 118. As used herein, a "package" it a term of art referring specifically to a chip carrier (also known as a chip container or chip package) that functions as the protective container housing an integrated circuit. That is, a package is the housing that integrated circuit chips come in that provide for mechanically and electrically coupling of the integrated circuit to an external circuit, such as a printed circuit board. Electrical connections may be performed via either socket or surface mounting. As such, a package will usually provide metal leads or pads, which are sturdy enough to electrically and mechanically connect the fragile chip to the printed circuit board.

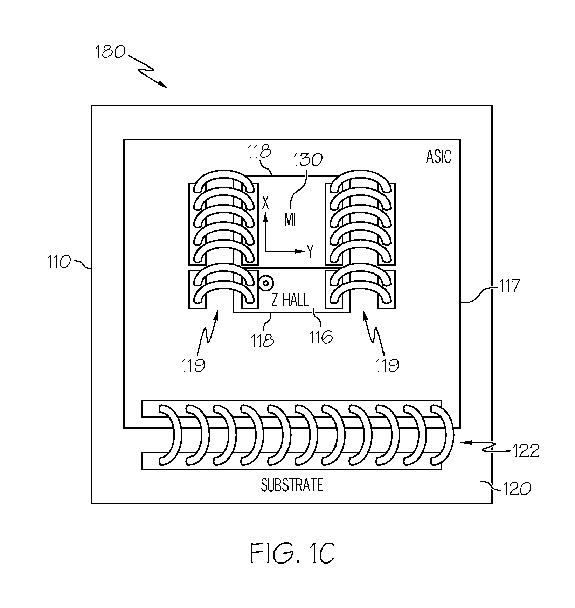

The single chip die 118 is electrically coupled to ASIC 117 via a first plurality of wirebond connections 119. ASIC 117 is in turn electrically coupled to substrate 120 via a second plurality of wirebond connections 122. In this way, electrical signals representing measurements produced by sensors 115 and 116 are delivered devices external to sensor package 110. Although Figures 1A and 1B illustrate three-axis magnetic sensor package 110 as having a magneto-resistance sensor, in other embodiments, such as shown in Figure 1C generally at 180, an in-plane sensor 130 is instead implemented as a magneto-inductive (MI) sensor. In either of the embodiments of Figure 1A or Figure 1C, the in-plane magnetic sensors (115, 130) may further comprise a single sensor device that is sensitive to magnetic fields in two directions, or may instead comprise two individual single-axis sensors oriented perpendicular to each other.

From a manufacturing standpoint, because two different sensor technologies are combined (that is, MR/MI sensor technology and Hall sensor technology), two distinct sets of process tools are required to form the sensors on the common substrate. That is, the process tools used to form MR/MI sensors are based on different underlying technologies than the process tools used to form Hall sensors. For example, thin film MR/MI processing utilizes technologies such as photolithography and requires precision deposition tools for sputtering an MR/MI substance layers onto an electrically insulating base layer. Hall sensors, in contrast, are semiconductor devices formed from material such as gallium arsenide (GaAs), indium antimonide (InSb) or indium arsenide (InAs). Once the sensors are formed, integrating the sensors within a common ASIC utilize standard manufacturing processes with no need to rotate die components to achieve the desired configuration of three orthogonal sensor. For example wirebonding of the sensors can be performed using normal techniques from above to create connections of the appropriate thickness. In addition to wirebonds (119, 122), other device interconnections can be made using standard wafer processing, through silicon vias (TSV, such as shown at 124), wafer bumps, wafer reconstitution, or other know techniques.

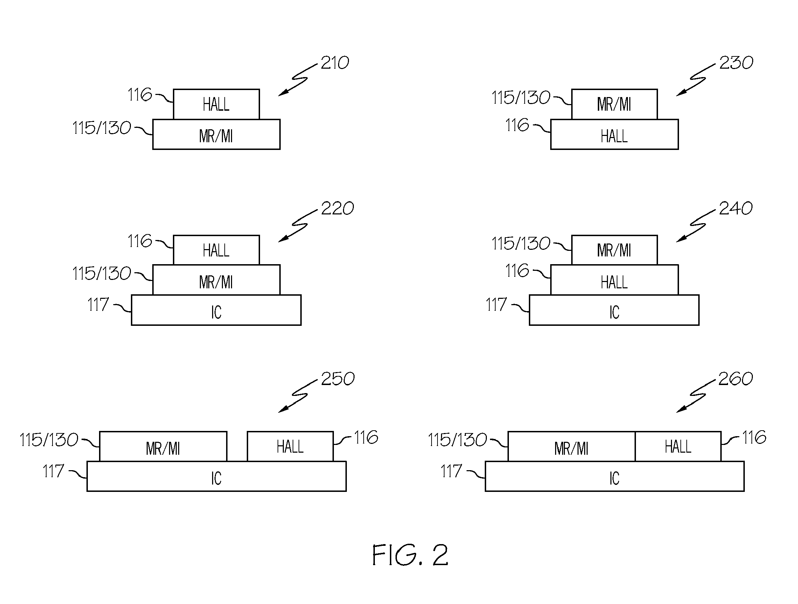

As illustrated in Figure 2, there are various possibilities for arranging the in-plane (shown as MR/MI) sensors and out-of-plane (shown as Hall) sensors within package 110. An embodiment having an out-of-plane magnetic sensor 116 formed on top of an in-plane two-axis magnetic sensor 115, 130 is shown generally at 210. In one embodiment, the in-plane two-axis magnetic sensor 115, 130 is further formed on top of the integrated circuit 117 as shown generally at 220. In another embodiment, an in-plane two-axis magnetic sensor 115, 130 is formed on top of an out-of-plane magnetic sensor 116 as shown generally at 230. In one embodiment, the out-of-plane magnetic sensor 116 is further formed on a surface of the integrated circuit 117 as shown generally at 240. In yet another embodiment, the in-plane two-axis magnetic sensor 115, 130 the out-of-plane magnetic sensor 116 are both formed on a surface of the integrated circuit 117, as shown generally at 250. In one embodiment, the in-plane two-axis magnetic sensor 115, 130 and the out-of-plane magnetic sensor 116 are formed adjacent to each other on a surface of the integrated circuit 117, as shown generally at 260. In alternate embodiment, the in-plane two-axis magnetic sensor 115, 130 and the out-of-plane magnetic sensor 116 are processed on a single wafer and/or made as discrete die (chips) and packaged together. Electrical connections between these components may be achieved using wirebonds (as discussed above) or through one or more through silicon vias (TSVs). Figure 2 is intended to provide examples of alternate arrangements and is not to be taken as limiting embodiments of the present invention only to those arrangements shown.

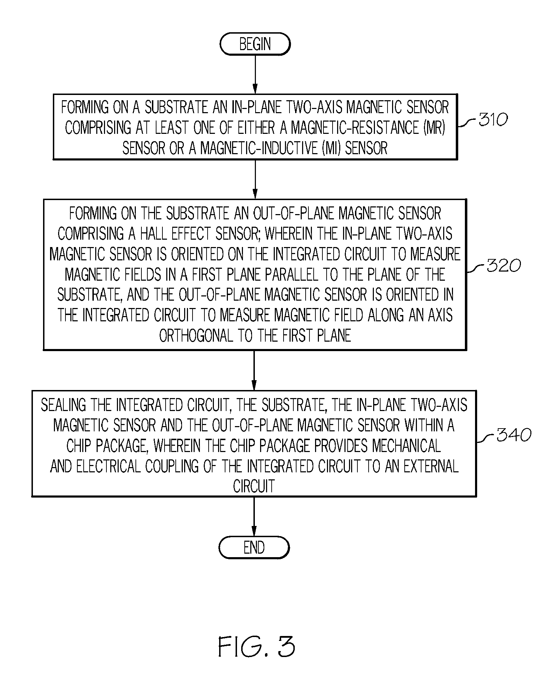

Figure 3 is a flow chart illustrating a method for a three-axis magnetic sensor. In one embodiment, the three-axis magnetic sensor comprises one of the three-axis magnetic sensors discussed above with respect to Figures 1A-C and arranged such as shown in one of the configurations illustrated in Figure 2. The method begins at 310 with forming on a substrate an in-plane two-axis magnetic sensor comprising at least one of either a magnetic-resistance (MR) sensor or a magnetic-inductive (MI) sensor. The MR sensor may include sensor technologies such as, but not limited to, an anisotropic magneto-resistance (AMR) sensor, a Giant Magneto-Resistance (GMR) sensor, or Tunnel Magneto-resistance (TMR) sensor. In one embodiment, the in-plane two-axis magnetic sensor is formed using thin film processing utilizing technologies such as, but not limited to, photolithography, and using deposition tools for sputtering an MR/MI substance layer onto an electrically insulating base layer.

The method proceeds to 320 with forming on the substrate an out-of-plane magnetic sensor comprising a Hall effect sensor. The in-plane two-axis magnetic sensor is oriented on the integrated circuit to measure magnetic fields in a first plane parallel to the plane of the substrate, and the out-of-plane magnetic sensor is oriented in the integrated circuit to measure magnetic field along an axis orthogonal to the first plane. In one embodiment, the out-of-plane magnetic sensor is formed from semiconductor materials such as gallium arsenide (GaAs), indium antimonide (InSb) or indium arsenide (InAs). As mentioned above, these in-plane and out-of-plane sensors may be processed on a single wafer and/or made as discrete die (chips) and packaged together.

The method proceeds to 330 with sealing the integrated circuit, the substrate, the in-plane two-axis magnetic sensor and the out-of-plane magnetic sensor within a chip package, wherein the chip package provides mechanical and electrical coupling of the integrated circuit to an external circuit. In one embodiment, the in-plane and out-of-plane sensors are electrically coupled to the integrated circuit using a plurality of wirebond connections and/or one or more through silicon vias (TSV). The integrated circuit is in turn electrically coupled to the substrate via a plurality of wirebond connections and/or one or more through silicon vias. In this way, measurements produced by both sensors are provided as electrical signals to devices external to the sensor package.

### EXAMPLE EMBODIMENTS

Example 1 includes a three-axis magnetic sensor formed on a single substrate, the sensor comprising an in-plane two-axis magnetic sensor comprising at least one of either a magnetic-resistance (MR) sensor or a magnetic-inductive (MI) sensor formed on the single substrate; an out-of-plane magnetic sensor comprising a Hall effect sensor formed on the single substrate; wherein the in-plane two-axis magnetic sensor measures magnetic fields in a first plane parallel to a plane of the substrate, and the out-of-plane magnetic sensor measures magnetic fields along an axis orthogonal to the first plane.

Example 2 includes the sensor of Example 1, wherein the two-axis magnetic sensor comprises at least one of an anisotropic magneto-resistance (AMR) sensor, a Giant Magneto-Resistance (GMR) sensor, or a Tunnel Magneto-resistance (TMR) sensor.

Example 3 includes the sensor of any of Examples 1-2, wherein the in-plane two-axis magnetic sensor is electrically coupled to an integrated circuit using at least one of a wirebond or a through silicon via (TSV).

Example 4 includes the sensor of Example 3, wherein the integrated circuit is electrically coupled to the substrate using at least one of a wirebond or a through silicon via (TSV).

Example 5 includes the sensor of any of Examples 1-4, wherein the in-plane two-axis magnetic sensor further comprises a first magnetic sensor die and a second magnetic sensor die oriented perpendicular to the first magnetic sensor die.

Example 6 includes the sensor of any of Examples 1-5, wherein the in-plane two-axis magnetic sensor is formed on top of the out-of-plane magnetic sensor.

Example 7 includes the sensor of Example 6, wherein the out-of-plane magnetic sensor is formed on a surface of an integrated circuit.

Example 8 includes the sensor of any of Examples 1-5, wherein the out-of-plane magnetic sensor is formed on top of the in-plane two-axis magnetic sensor.

Example 9 includes the sensor of Example 8, wherein the in-plane two-axis magnetic sensor is formed on a surface of a integrated circuit.

Example 10 includes the sensor of any of Examples 1-5, wherein the in-plane two-axis magnetic sensor and the out-of-plane magnetic sensor are formed adjacent to each other on a surface of the substrate.

Example 11 includes the sensor of any of Examples 1-10, further comprising a package housing the integrated circuit, the substrate, the in-plane two-axis magnetic sensor and the out-of-plane magnetic sensor; wherein the package provides mechanical and electrical coupling of the integrated circuit to an external circuit.

Example 12 includes an application specific integrated circuit (ASIC) for a three-axis magnetic sensor, the circuit comprising a substrate; a thin-film two-axis magnetic sensor formed on the substrate and sensitive to magnetic fields in-plane with respect to the substrate; a magnetic sensor semiconductor die formed on the substrate and sensitive to magnetic fields orthogonal to magnetic fields sensed by the thin-film two-axis magnetic sensor; a package housing the substrate, the thin-film two-axis magnetic sensor and the magnetic sensor semiconductor die, wherein the package provides mechanical and electrical coupling of the thin-film two-axis magnetic sensor and the magnetic sensor semiconductor die to an external circuit.

Example 13 includes the circuit of Example 12, wherein the magnetic sensor semiconductor die comprises a Hall sensor; and wherein the thin-film two-axis magnetic sensor comprises at least one of either a magnetic-resistance (MR) sensor or a magnetic-inductive (MI) sensor.

Example 14 includes the circuit of any of Examples 12-13, wherein the two-axis magnetic sensor comprises at least one of an anisotropic magneto-resistance (AMR) sensor, a Giant Magneto-Resistance (GMR) sensor, or a Tunnel Magneto-resistance (TMR) sensor.

Example 15 includes the circuit of any of Examples 12-14, wherein the thin-film two-axis magnetic sensor further comprises a first magnetic sensor die and a second magnetic sensor die oriented perpendicular to the first magnetic sensor die.

Example 16 includes the circuit of any of Examples 12-15, wherein the thin-film two-axis magnetic sensor is formed on top of the magnetic sensor semiconductor die.

Example 17 includes the circuit of any of Examples 12-15, wherein the magnetic sensor semiconductor die is formed on top of the thin-film two-axis magnetic sensor.

Example 18 includes the circuit of any of Examples 12-15, wherein the magnetic sensor semiconductor die and the thin-film two-axis magnetic sensor are formed adjacent to each other.

Example 19 includes a method for forming a three-axis magnetic sensor on a single substrate, the method comprising forming on a substrate an in-plane two-axis magnetic sensor comprising at least one of either a magnetic-resistance (MR) sensor or a magnetic-inductive (MI) sensor; forming on the substrate an out-of-plane magnetic sensor comprising a Hall effect sensor; wherein the in-plane two-axis magnetic sensor is oriented on the integrated circuit to measure magnetic fields in a first plane parallel to the plane of the substrate, and the out-of plane magnetic sensor is oriented in the integrated circuit to measure magnetic field along an axis orthogonal to the first plane; and sealing the integrated circuit, the substrate, the in-plane two-axis magnetic sensor and the out-of-plane magnetic sensor within a chip package, wherein the chip package provides mechanical and electrical coupling of the integrated circuit to an external circuit.

Example 20 includes the method of Example 19, wherein the two-axis magnetic sensor comprises at least one of an anisotropic magneto-resistance (AMR) sensor, a Giant Magneto-Resistance (GMR) sensor, or a Tunnel Magneto-resistance (TMR) sensor.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof.

## Claims

1. A three-axis magnetic sensor formed on a single substrate (120), the sensor comprising:
an in-plane two-axis magnetic sensor (115) comprising at least one of either a magnetic-resistance (MR) sensor or a magnetic-inductive (MI) sensor formed on the single substrate (120);
an out-of-plane magnetic sensor (116) comprising a Hall effect sensor formed on the single substrate (120);
wherein the in-plane two-axis magnetic sensor (115) measures magnetic fields in a first plane parallel to a plane of the substrate (120), and the out-of-plane magnetic sensor (116) measures magnetic fields along an axis orthogonal to the first plane.

2. The sensor of claim 1, wherein the two-axis magnetic sensor (115) comprises at least one of an anisotropic magneto-resistance (AMR) sensor, a Giant Magneto-Resistance (GMR) sensor, or a Tunnel Magneto-resistance (TMR) sensor.

3. The sensor of claim 1, wherein the in-plane two-axis magnetic sensor (115) is electrically coupled to an integrated circuit (117) using at least one of a wirebond (119) or a through silicon via (TSV);
wherein the integrated circuit (117) is electrically coupled to the substrate (120) using at least one of a wirebond (122) or a through silicon via (TSV).

4. The sensor of claim 1, wherein the in-plane two-axis magnetic sensor (115) further comprises a first magnetic sensor die and a second magnetic sensor die oriented perpendicular to the first magnetic sensor die.

5. The sensor of claim 1, wherein the in-plane two-axis magnetic sensor (115) is formed on top of the out-of-plane magnetic sensor (116);
wherein the out-of-plane magnetic sensor (116) is formed on a surface of an integrated circuit (117).

6. The sensor of claim 1, wherein the out-of-plane magnetic sensor (116) is formed on top of the in-plane two-axis magnetic sensor (115);
wherein the in-plane two-axis magnetic sensor (115) is formed on a surface of a integrated circuit (117).

7. The sensor of claim 1, wherein the in-plane two-axis magnetic sensor (115) and the out-of-plane magnetic sensor are formed adjacent to each other on a surface of the substrate (120).

8. The sensor of claim 1, further comprising:
a package housing the integrated circuit, the substrate (120), the in-plane two-axis magnetic sensor (115) and the out-of-plane magnetic sensor (116);
wherein the package provides mechanical and electrical coupling of the integrated circuit (117) to an external circuit.

9. A method for forming a three-axis magnetic sensor on a single substrate (120), the method comprising:
forming (310) on a substrate (120) an in-plane two-axis magnetic sensor (115) comprising at least one of either a magnetic-resistance (MR) sensor or a magnetic-inductive (MI) sensor;
forming (320) on the substrate (120) an out-of-plane magnetic sensor (116) comprising a Hall effect sensor;
wherein the in-plane two-axis magnetic sensor (115) is oriented on an integrated circuit (117) to measure magnetic fields in a first plane parallel to the plane of the substrate (120), and the out-of-plane magnetic sensor (116)is oriented in the integrated circuit (117) to measure magnetic field along an axis orthogonal to the first plane; and
sealing (340) the integrated circuit (117), the substrate (120), the in-plane two-axis magnetic sensor (115) and the out-of-plane magnetic sensor (116) within a chip package, wherein the chip package provides mechanical and electrical coupling of the integrated circuit (117) to an external circuit.

10. The method of claim 9, wherein the two-axis magnetic sensor (115) comprises at least one of an anisotropic magneto-resistance (AMR) sensor, a Giant Magneto-Resistance (GMR) sensor, or a Tunnel Magneto-resistance (TMR) sensor.
